# DEMANDE DE BREVET EUROPEEN

(11) **EP 2 608 114 A1**
(43) Date de publication de la demande: **26.06.2013**
(21) Numéro de dépôt: 11306701.1
(22) Date de dépôt: 19.12.2011
(51) Int. Cl.: G06K 19/077, G06K 19/07

(54) **Procédé de fabrication d'un module à puce de circuit intégré protégé par pastille**

(71) Demandeur: Gemalto SA, 92190 Meudon (FR)
(72) Inventeur: Seban, Frédérick, 13260 CASSIS (FR); Buyukkalender, Arek, 13013 MARSEILLE (FR); Lahoui, Nizar, 13400 AUBAGNE (FR); Dossetto, Lucile, 83270 SAINT CYR SUR MER (FR); Ottobon, Stéphane, 83270 SAINT CYR SUR MER (FR); Robertet, Laurence, 13420 GEMENOS (FR)

(57) **Abrégé**

L'invention concerne un procédé de fabrication d'un module (1) à puce de circuit intégré comprenant les étapes suivantes :
- de réalisation de pistes ou plages conductrices (2, 15a, 115b) sur un support isolant (3, 3A),
- de report et connexion d'une puce de circuit intégré (4) aux pistes ou plages conductrices,
- de recouvrement de la puce par une pastille de protection (7) ou d'un capot de protection présentant une face recto (8) et une face verso (9) opposée à la face recto ;

Le procédé se distingue en ce qu'il comprend l'étape de réalisation ou de fixation d'au moins un élément additionnel (10) sur ladite pastille parmi un composant électrique et/ou électronique, une piste ou plage de contact, un élément de sécurité.

L'invention concerne également un objet portable électronique comprenant le module obtenu par le procédé.

## Description

### Domaine de l'invention.

L'invention concerne un procédé de fabrication d'un module à puce de circuit intégré protégé par une pastille de renfort et/ou de protection. Elle concerne également des modules de circuit intégré obtenus par le procédé.

L'invention peut concerner notamment le domaine des supports électroniques tels que des passeports électroniques, cartes à puce à contacts ou sans contact ou cartes hybrides, tickets ou étiquettes radiofréquences, transpondeurs radiofréquences, inserts (ou inlay) intégrant ou constituant un tel module.

De tels objets peuvent être conformes notamment au standard ISO / IEC 14443 ou ISO 78016.

### Art antérieur.

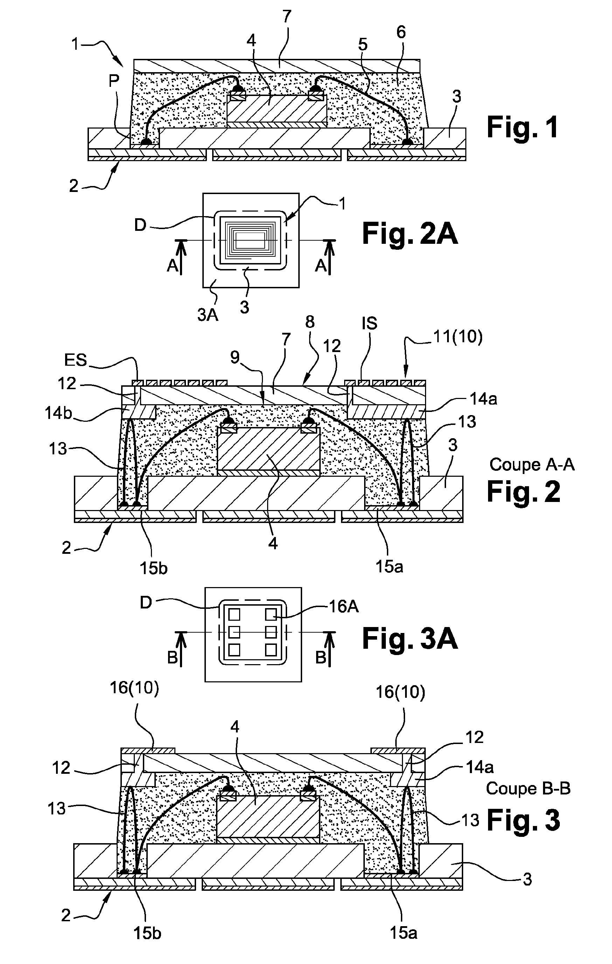

Il est connu de fabriquer un module de carte à puce (illustré à la figure 1) par les étapes suivantes :
- de réalisation de pistes ou plages conductrices sur un support continu diélectrique ou isolant,
- de reporter au moins une puce de circuit intégré sur le support,
- de connecter la puce aux pistes ou plages conductrices notamment par fil soudé, colle conductrice,
- d'enrober au moins la puce et/ou ses connexions par une résine de protection ;

La résine est ensuite recouverte, en grande partie dans certains cas, par une pastille isolante semi-rigide.

### Problème technique.

La surface disponible d'un module à contacts du type carte à puce, pour recevoir des composants, est généralement réduite à la surface du support opposée à celle recevant les plages de contact qui sont destinées à connecter un connecteur de lecteur. Des pistes conductrices et/ou des bobines radiofréquences peuvent résider sur la surface opposée du support portant des plages de contact. On parle alors de module double face.

La faible surface disponible sur un module rend complexe sa conception et augmente les risques de rebut.

Le problème ci-dessus est identifié par les inventeurs. L'invention a donc pour objectif de faciliter et simplifier la fabrication des modules tout en trouvant plus de place pour loger des composants électriques et/ou électroniques.

### Résumé de l'invention.

L'invention consiste à utiliser la surface de la pastille de module (recto et/ou verso), inutilisée jusqu' à présent, pour supporter des composants électriques et/ou électroniques ou des pistes ou des plages de contact ou des éléments divers notamment de sécurité.

Ainsi on réalise avantageusement un support de composant ou d'éléments sur un substrat distinct du substrat portant la puce électronique.

L'invention a donc pour objet un procédé de fabrication d'un module à puce de circuit intégré conforme à la revendication 1.

D'autres caractéristiques et mode de mise en oeuvre font l'objet des revendications 2 à 7.

L'invention a également pour objet un module correspondant au procédé et un objet à puce électronique comportant ce module.

L'objet peut constituer de préférence un passeport, un livret. Dans le cas d'un module à antenne, cette dernière peut être portée par une feuille ou une couverture du livret ou du passeport.

Brève description des figures.
- La figure 1 illustre un module à puce électronique de l'art antérieur ;
- La figure 2 est en vue de dessus un module obtenu selon un premier mode de mise en oeuvre du procédé de l'invention ;
- La figure 2A illustre un module, en coupe transversale de la figure 2 ;
- La figure 3 est un module obtenu selon un second mode de mise en oeuvre du procédé ;
- La figure 3A illustre un module, en coupe transversale de la figure 3 ;
- La figure 4 illustre un module obtenu selon un troisième mode de mise en oeuvre du procédé de l'invention ;
- La figure 5 illustre un module obtenu selon un quatrième mode de mise en ouvre du procédé de l'invention ;
- La figure 6 illustre un module obtenu selon un cinquième mode de mise en oeuvre du procédé de l'invention.

### Description

La figure 1 illustre un module à puce de circuit intégré 1 de l'art antérieur. Il comprend des pistes conductrices 2 sur un support 3 diélectrique ou isolant notamment du type LFCC (Lead frame contrecollé), au moins une puce de circuit intégré 4 reportée sur le support ou des plages de contact. Il comprend également une connexion 5 notamment par fil soudé, par colle conductrice, la puce étant retournée (flip-chip) ou non, un enrobage 6 de la puce et/ou de ses connexions par une matière de protection telle une résine (glob-top), qui peut être déposée par exemple sous forme de goutte ou déposée par surmoulage. L'enrobage est recouvert par une pastille isolante rigide ou semi-rigide 7 qui a notamment pour effet d'aplanir un bombé naturel de la goutte de résine et/ou de renforcer la protection du circuit intégré. Dans certains cas, on peut renforcer la pastille par un chapeau ou capot de protection du circuit intégré avec ou sans résine de protection.

Les figures 2, 2A illustrent un module à puce 7 obtenu par un premier mode de mise en oeuvre du procédé de l'invention. Les mêmes références d'une figure à l'autre indiquent des moyens identiques ou similaires.

Selon ce premier mode, le procédé de fabrication d'un module à puce de circuit intégré comprenant les étapes de réalisation de pistes conductrices 2 et/ou plages de contacts 14 sur un support isolant 3 ; Le support peut être de préférence un film continu en bobine 3A (fig. 2A) à partir duquel le module 1 est découpé par la suite autour d'une ligne fictive préétablie de découpe D qui l'entoure.

Le procédé comprend également un report et une connexion d'une puce de circuit intégré 4 aux pistes ou plages conductrices de contact, puis un recouvrement de la puce par une pastille de protection 7 (alternativement d'un capot de protection) présentant une face recto 8 (face libre orientée vers l'extérieur) et une face verso 9 (orientée vers la résine 6) opposée à la face recto.

Selon une caractéristique de ce premier mode, le procédé comprend l'étape de réalisation ou de fixation d'au moins un élément additionnel 10 sur ladite pastille ;

Cet élément peut être trouvé parmi un composant électrique et/ou électronique et/ou une piste ou plage de contact et/ou un élément de sécurité (marquage ou autre).

Dans l'exemple, 1 élément 10 comprend une antenne ou bobine radiofréquence 11. L'antenne est réalisée ici par gravure sur la face 8 recto de la pastille. Des vias conducteurs (trous métallisés) 12 traversent la pastille pour connecter des plages ou pistes de connexions 14a, 14b situées sur la face 9 opposée (verso). Tout type d'antenne peut être envisagé notamment du type UHF.

L'invention utilise à bon escient l'espace disponible procuré par les surfaces recto et/ou verso de la pastille. Cet espace n'a jamais été utilisé à ce jour dans le but de l'invention.

Selon une caractéristique, le procédé comprend également une étape de réalisation d'au moins une liaison d'interconnexion et/ou de communication 13 entre la puce et ledit élément 10 ou entre des surfaces de connexion situées sur la pastille et celles situées sur le substrat isolant 3 du module. Cette opération de connexion est difficile car elle s'effectue ici dans l'enrobage et sans visibilité. Généralement, les connexions s'effectuent avant tout enrobage.

Ici, dans l'exemple, la liaison d'interconnexion s'établit entre au moins un premier contact 14a, 14b disposé sur le support isolant 3 et un second contact électrique 15a, 15b disposé sur la pastille 7. Dans la description, la pastille peut être remplacée indifféremment par un capot ou chapeau, cloche de protection.

Selon une caractéristique d'un mode de réalisation, l'interconnexion électrique 13 est réalisée par technique de fil soudé ou élément ressort. L'élément est un fil en forme de boucle, soudé deux fois sur le contact 15a par deux ses deux extrémités. Le sommet de la boucle 13 connecte par contact électrique le contact 14a, 14b de la pastille. La plage de contact 14a relie une extrémité IS d'une spire interne de l'antenne 11 par un via conducteur 12 tandis qu'une autre plage de contact 14b relie l'extrémité ES d'une spire externe de l'antenne par un autre via conducteur 12.

Alternativement, le fil soudé pourrait à l'inverse être soudé par deux points sur la plage de contact 14 ou autre surface de contact de la pastille tandis que la boucle connecte par son sommet ou milieu, une surface de contact disposée sur le substrat 3. Le cas échéant, le point de contact peut être collé par une goutte de colle conductrice notamment dans un puits P du substrat 3.

Les boucles peuvent être réalisées avantageusement sur un équipement de connexion de puce et en continu sur un ruban simple ou double face. Comme pour un module de type carte à puce, les pastilles dotées des composants supplémentaires ou éléments divers peuvent être extraites ultérieurement du ruban.

Le cas échéant, la puce 4 (ou une autre puce) peut être fixée sur la pastille isolante 7 ; Des connexions notamment par l'intermédiaire des étais ou du sommet de la boucle d'une puce de la pastille 7 peuvent connecter la puce 4 ou une autre puce à des plages de contact sur le substrat 3.

Selon une autre caractéristique d'un mode de réalisation, l'interconnexion électrique 13 est réalisée dans ou à travers une résine d'enrobage 6 disposée sous la pastille sur la puce et/ou ses connexions.

La puce peut ou non être connectée par des fils soudés, à des plages de contacts du module ou substrat 3 (notamment par bossages conducteurs de la face active, la puce étant retournée). D'autre modes de connexions sont envisageables.

Aux figures 3 et 3A, la structure diffère de la figure précédente 2 par des plages de contacts électriques 16 constituant l'élément additionnel 10 à la place de l'antenne 11. Ces plages de contact peuvent permettre une connexion à la puce 4 autrement que par les plages de contacts habituelles d'une carte à puce. Par exemple, ces plages de contact 16 peuvent déboucher sur une face arrière de corps de carte à puce (non représenté) opposée à celle comportant généralement les plages de contact d'interface avec un lecteur, le module étant traversant et/ou ayant quasiment la même épaisseur que le corps de carte.

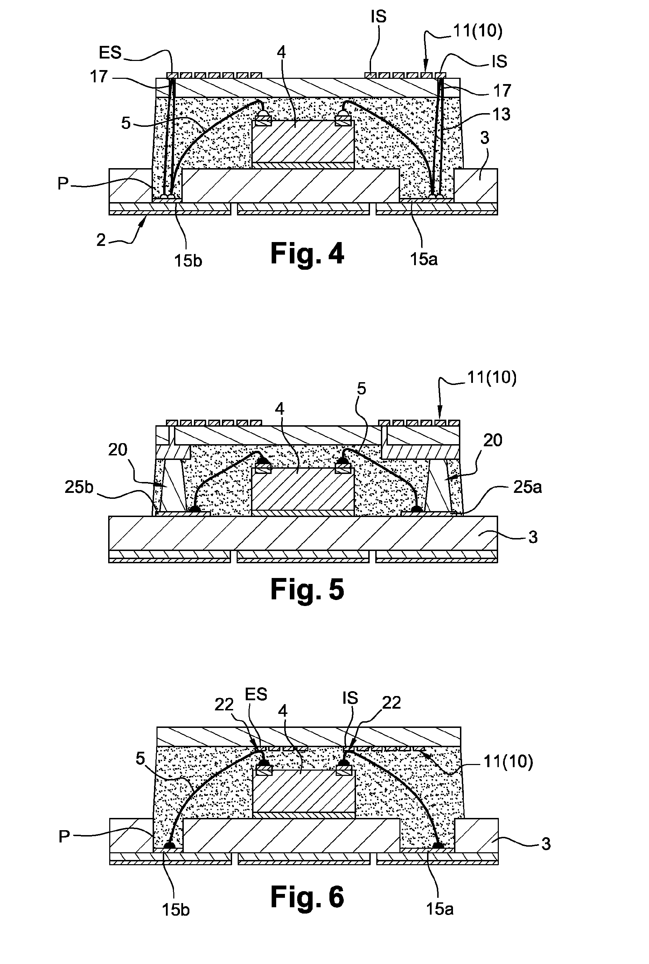

A la figure 4, la structure diffère de la figure 2 par des puits ou fentes 17 réalisés dans la pastille à la place des vias conducteurs 12. A l'assemblage, les connexions en fils soudés (appelées aussi étais 13) traversent les puits 17 pour connecter des extrémités de connexion IS, ES de l'antenne. Le point de connexion IS de la spire interne est ici redirigé par un pont isolé (non représenté) des spires de l'antenne vers un point de connexion à l'extérieur de la spire externe.

A la figure 5, la structure diffère de la figure 2 par le fait que les éléments de connexions filaires soudés et en forme d'étais 13 sont réalisés sous forme de bossages 20, par exemple cylindriques ou coniques. Le bossage 20 peut être réalisé par exemple en colle conductrice flexible.

Contrairement à la figure 2, des surfaces de connexion 25a, 25b sont réalisée sur le substrat du côté de la puce ; Chaque base de bossage conique 20 repose sur chaque surface de connexion. Alternativement, le bossage 20 pourrait traverser le substrat 3 par un perçage pour connecter des surfaces de contact comme à la figure 2 disposées sur la face du substrat opposée à la puce.

A la figure 6, selon un autre mode de réalisation de l'invention, le module diffère du module de la figure 1 en ce qu'il comporte un élément additionnel 10 sur la face verso côté résine ; Ici, il s'agit de l'antenne 11.

Ce mode illustre également une double connexion d'un fil soudé 13 utilisé à la fois pour connecter des plages de contact sur le substrat 3 et des plages de contact disposée sur la pastille. Ces plages conductrices de la pastille constituent les extrémités ES, IS de connexion de l'antenne. Le fil soudé en forme de boucle, comporte un sommet 22 qui est utilisé ici pour connecter un des contacts électrique de la pastille 7.

L'antenne 11 peut être une antenne (11) radiofréquence passive ou active. Par exemple, l'antenne passive ou relais (non reliée à la puce) peut être de préférence sur le substrat 3 le plus étendu tandis que l'antenne active de transpondeur est reliée à la puce qui se trouve sur la pastille 7.

Comme autre variante d'utilisation ou mise en oeuvre de l'invention, des spires d'antenne portées par la pastille 7 peuvent constituer un complément de spires par rapport à d'autres spires disposées sur le substrat (série, parallèles).

Des éléments de sécurité peuvent être compris sur la pastille, par exemple, un marquage laser, UV, un hologramme, une surface lenticulaire, tout élément de sécurité généralement réalisé sur le corps de carte ou le module ou autre objet à puce de circuit intégré.

Ainsi, la personnalisation et la sécurité graphique peuvent commencer à la réalisation du module notamment sur un substrat en forme de ruban de bobine et s'effectuer en continu avec des équipements pour ruban de bobine.

La pastille 7 peut comporter comme composant, par exemple, une diode luminescente qui va s'éclairer au cours d'une transaction radiofréquence, la diode étant alimentée par l'énergie du champ radiofréquence via une antenne bobinée.

La pastille peut comporter comme autre élément additionnel, un capteur biométrique ; Ce dernier étant accessible par exemple sur une face arrière d'une carte à puce.

Le capot peut être formé par exemple avec une paroi périphérique supplémentaire reliant et entourant le bord périphérique de la pastille 7 et s'étendant de la périphérie vers le substrat.

Le procédé de l'invention peut contribuer à l'obtention de tout objet portable électronique comportant le transpondeur ou module décrit ci-dessus.

En particulier, l'objet peut comprendre un passeport, un livret, le transpondeur étant porté par une feuille ou une couverture du livret.

## Revendications

1. Procédé de fabrication d'un module (1) à puce de circuit intégré comprenant les étapes suivantes :
- de réalisation de pistes conductrices (2, 15a, 115b) sur un support isolant (3, 3A),
- de report et connexion d'une puce de circuit intégré (4) aux pistes ou plages conductrices,
- de recouvrement de la puce par une pastille de protection (7) ou d'un capot de protection présentant une face recto (8) et une face verso (9) opposée à la face recto,
**caractérisé en ce qu'**il comprend l'étape de réalisation ou de fixation d'au moins un élément additionnel (10) sur ladite pastille parmi un composant électrique et/ou électronique, une piste ou plage de contact, un élément de sécurité.

2. Procédé selon la revendication précédente, **caractérisé en ce qu'**il comprend une étape de réalisation d'au moins une liaison (13, 20) d'interconnexion et/ou de communication entre la puce et ledit élément additionnel (10).

3. Procédé selon l'une quelconque des revendications précédentes, **caractérisé en ce que** la liaison d'interconnexion (13, 20) s'établit entre au moins un premier contact (15a, 15b) disposé sur le support isolant et un second contact (14a, 14b) disposé sur la pastille (7) ou capot.

4. Procédé selon l'une quelconque des revendications précédentes, **caractérisé en ce que** l'interconnexion électrique (13) est réalisée par une technique de fil soudé, par un élément ressort ou une boucle conductrice.

5. Procédé selon l'une quelconque des revendications précédentes, **caractérisé en ce que** l'interconnexion électrique (13) est noyée dans une résine d'enrobage (6) disposée sous la pastille ou capot.

6. Procédé selon l'une quelconque des revendications précédentes, **caractérisé en ce que** l'interconnexion électrique est réalisée sur le parcours d'un même fil soudé 13 s'étendant d'un plot de puce 4 à un premier contact (15a, 15b) sur le support.

7. Procédé selon la revendication précédente, **caractérisé en ce que** ledit élément additionnel comprend une antenne (11) radiofréquence passive ou active.

8. Module à puce de circuit intégré comprenant :
- des pistes ou plages conductrices réalisées sur un support isolant,
- une puce de circuit intégré connectée aux pistes ou plages conductrices,
- une pastille de protection ou un capot de protection présentant une face recto et une face verso opposée à la face recto, pour un recouvrement de la puce,
**caractérisé en ce qu'**il comprend au moins un élément additionnel réalisé ou fixé sur ladite pastille parmi un composant électrique et/ou électronique, une piste ou plage de contact, un élément de sécurité.

9. Objet à puce de circuit intégré comprenant le module selon la revendication précédente.
